Europäisches Patentamt

European Patent Office

Office européen des brevets

(19)

(11) EP 0 620 444 B1

(12) EUROPEAN PATENT SPECIFICATION

(45) Date of publication and mention
of the grant of the patent:
07.07.1999 Bulletin 1999/27

(51) Int Cl.6: G01R 21/127

(21) Application number: 94105557.6

(22) Date of filing: 11.04.1994

(54) **Measurement circuit for measurement apparatuses intended for measurements of energy in a three-phase network**

Messanordnung für Messgeräte zum Messen von Energie in einem Dreiphasennetz

Dispositif de mesure pour appareils de mesure destinés à des mesures d'énergie dans un réseau triphasé

(84) Designated Contracting States:
AT BE CH DE DK ES FR GB GR IE IT LI LU MC NL PT SE

(30) Priority: 16.04.1993 FI 931753

(43) Date of publication of application:
19.10.1994 Bulletin 1994/42

(73) Proprietor: ENERMET OY
SF-40420 Jyskä (FI)

(72) Inventors:
• Tähti, Erkki
SF-40600 Jyväskylä (FI)
• Korkolainen, Tuomo
SF-40500 Jyväskylä (FI)

(74) Representative: Tiedtke, Harro, Dipl.-Ing.
Patentanwaltsbüro
Tiedtke-Bühling-Kinne & Partner
Bavariaring 4
80336 München (DE)

(56) References cited:
EP-A- 0 049 520          WO-A-82/03276
WO-A-85/00893          GB-A- 2 025 072
GB-A- 2 094 989

• INTERNATIONAL JOURNAL OF ELECTRONICS,
vol.57, no.2, August 1984, BASINGSTOKE,
HAMPSHIRE, GB pages 267 - 276 VELAYUDHAN
ET AL. 'An electronic three-phase active and
reactive power transducer'

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The invention concerns a measurement circuit for measurement apparatuses intended for measurements of energy in a three-phase network, wherein output data are summed up in order to provide a result of measurement of the electrical three-phase power (energy).

As a rule, measurement apparatuses intended for measurements of energy in a three-phase network comprise internally two or three identical power measurement mechanisms, the output data of which are summed up. The connections of the measurement mechanisms with the electrical network are fixed, and the arrangement depends on which power (energy) quantity is supposed to be measured. The dimensioning of the voltage circuits of the measurement mechanisms also depends on the arrangement of the measurement mechanisms. Thus, by means of one measurement apparatus, it is possible to measure power of one type only, such as, for example, effective power or reactive power.

Document GB-A- 094 989 discloses an electronic watthour meter which includes a power flow direction detector circuit and a pulse width modulation circuit for converting a voltage signal proportional to the load voltage. In accordance with the output of the power flow direction circuit the polarity of the output signal of the pulse width modulation circuit is either inverted or not inverted. The electronic watthour meter further comprises a multiplication circuit which is controlled by the output of an inversion circuit and which produces an output representing the product of the voltage signal proportional to the load voltage and a voltage signal proportional to the load current. The output of the multiplication circuit is representative of the power consumed according to the direction of power flow.

In regard of the above prior art the object of the present invention is to provide an improvement over this prior art measurement arrangements for measurement apparatuses intended for measurements of power (energy) in a three-phase network. A more specific object of the invention is to provide a measurement circuit that permits measurement of power (energy) of different types by means of one and the same measurement apparatus.

According to the present invention, these objects are achieved by a measurement circuit for measurement apparatuses as defined in the appended claims.

According to the invention, the power measurement circuit is accomplished inside an electronic meter based on the pulse width-height multiplier by means of digital signals, which permits changing of the "wiring" (arrangement of measurement mechanisms) by means of control signals internal in the meter during operation of the meter without necessity to make changes in the outside connections of the meter or in the dimensioning of the voltage circuits. Thus, owing to the measurement circuit in accordance with the invention, by means of the same meter, it is possible to measure both effective power (effective energy) and reactive power (reactive energy) in the ways corresponding to a conventional measurement arrangement of two or three mechanisms and, moreover, by means of different variations of conventional arrangements of two mechanisms. The possibility of changing the arrangements of mechanisms is particularly advantageous in view of internal failure diagnostics of the meter, because, under normal conditions, the measurement results between different modes of measurement are within predictable error margins.

The invention will be described in detail with reference to a preferred embodiment of the invention illustrated in the figures in the accompanying drawings, the invention being, however, not supposed to be confined to said embodiment alone.

Figure 1 shows conventional measurement of effective power with 3 mechanisms.

Figure 2 shows conventional measurement of reactive power with 3 mechanisms.

Figure 3 shows conventional measurement of effective power with 2 mechanisms.

Figure 4 shows conventional measurement of reactive power with 2 mechanisms.

Figure 5 shows the measurement part of an electronic power meter in accordance with the present invention as a block diagram.

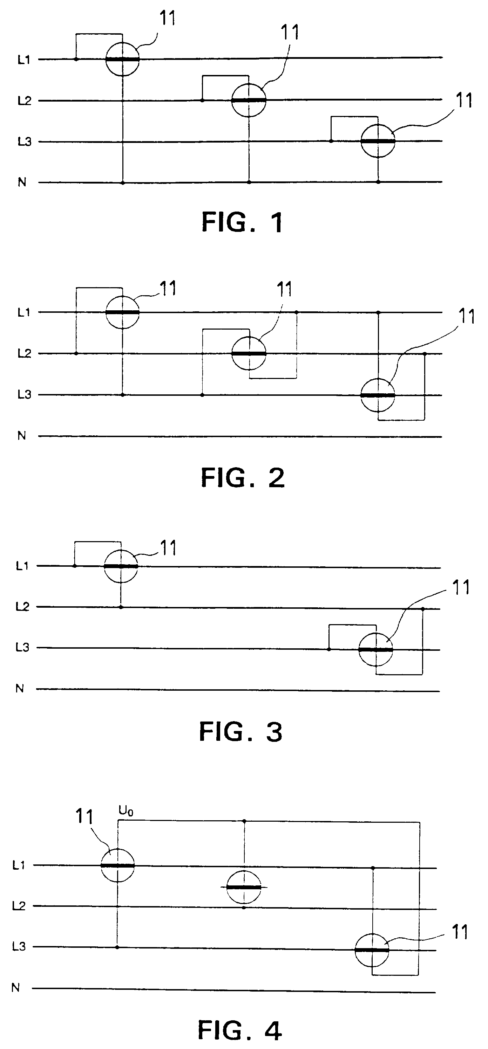

When a mode of measurement with three mechanisms as shown in Fig. 1 is used, the effective power P is obtained from the formula (1)

$$P = I_{L1}{}^{*}U_{L1} + I_{L2}{}^{*}U_{L2} + I_{L3}{}^{*}U_{L3} \tag{1}$$

When a mode of measurement with three mechanisms as shown in Fig. 2 is used, the reactive power Q is obtained from the formula (2)

$$Q = 1/\sqrt{3} * (I_{L1}{}^{*}(U_{L2}\text{-}U_{L3}) + I_{L2}{}^{*}(U_{L3}\text{-}U_{L1}) + I_{L3}{}^{*}(U_{L1}\text{-}U_{L2})) \tag{2}$$

When a mode of measurement with two mechanisms as shown in Fig. 3 is used, the effective power P is obtained from the formula (3)

$$P = I_{L1}*(U_{L1}-U_{L2}) + I_{L3}*(U_{L3}-U_{L2}) \tag{3}$$

When a mode of measurement with two mechanisms as shown in Fig. 4 is used, the reactive power Q is obtained from the formula (4)

$$Q = \sqrt{3} * (I_{L1}*(U_0-U_{L3}) + I_{L3}*(U_{L1}-U_0)) \tag{4}$$

In Figs. 1 to 4, the measurement mechanisms are denoted with the ref. numeral 11.

The formulae (1) ... (4) can be written in the forms (5) ... (8), which are more illustrative of the operation of the power meter in accordance with the invention:

Formula 1 is equivalent to:

$$P = 1/2 * ((I_{L1}*U_{L1}) + (-I_{L1} * -U_{L1}) +$$

$$(I_{L2}*U_{L2}) + (-I_{L2} * -U_{L2}) +$$

$$(I_{L3}*U_{L3}) + (-I_{L3} * -U_{L3})) \tag{5}$$

Formula 2 is equivalent to:

$$Q = 1/\sqrt{3} * ((I_{L1}*U_{L2}) + (-I_{L1} * U_{L3}) +$$

$$(I_{L2}*U_{L3}) + (-I_{L2} * U_{L1}) +$$

$$(I_{L3}*U_{L1}) + (-I_{L3} * U_{L2})) \tag{6}$$

Formula 3 is equivalent to:

$$P = (I_{L1}*U_{L1}) + (-I_{L1} * U_{L2}) +$$

$$(I_{L3}*U_{L3}) + (-I_{L3} * U_{L2}) \tag{7}$$

Formula 4 is equivalent to:

$$Q = \sqrt{3}/2 * ((I_{L1}*-U_{L3}) + (-I_{L1} * U_{L3}) +$$

$$(I_{L3}*U_{L1}) + (-I_{L3} * -U_{L1})) \tag{8}$$

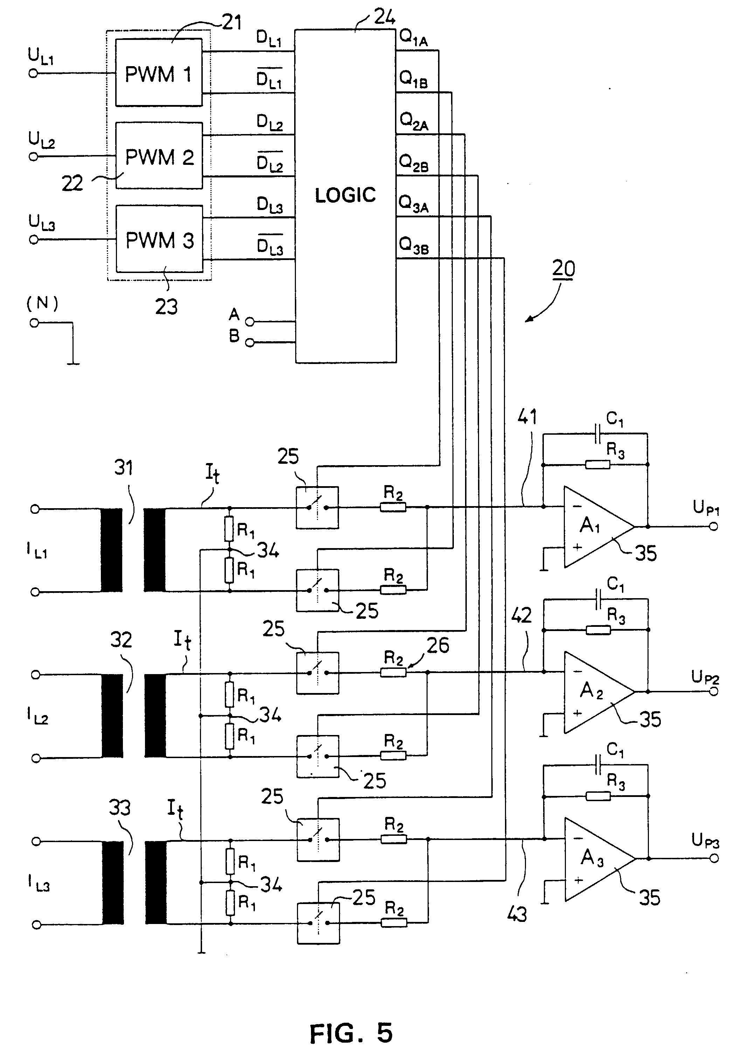

Figure 5 shows the power measurement part 20 of an electronic power or energy meter in accordance with the invention as a block diagram. The pulse-width modulators 21,22 and 23 form pulse-width modulated digital data $D_{L1}$, $D_{L2}$ and $D_{L3}$ and their negations $\overline{D_{L1}}$, $\overline{D_{L2}}$, $\overline{D_{L3}}$ out of each momentary value of the phase voltage of the three-phase network. The outputs of the pulse-width modulators 21,22 and 23 are synchronous with one another. The digital data $D_{L1}$, $D_{L2}$ and $D_{L3}$ and their negations $\overline{D_{L1}}$, $\overline{D_{L2}}$, $\overline{D_{L3}}$ are passed to the control logic 24, which gives the digital signals $Q_{1A}$, $Q_{1B}$, $Q_{2A}$, $Q_{2B}$, $Q_{3A}$ and $Q_{3B}$ to the switches 25 in the form of connectors included in the pulse width/height multiplier 26. The secondary current $I_t$ of the measurement transformer 31,32 and 33 of each phase current in the three-phase network passes through two resistors $R_1$ of equal size. The common point 34 of the resistors $R_1$ is connected to the zero potential of the measurement electronics, whereby voltages of equal absolute value but of opposite signs, and proportional to the phase current are effective across the resistors $R_1$. These voltages are connected by means of the switches 25 and the resistors $R_2$, each sum-current signal 41, 42 or 43 being proportional to the sum of the products of the phase voltages that control tile switches 25 via the pulse-width modulators 21, 22 and 23 and the control logic and of said phase-current dependent voltages of opposite signs. In the embodiment as shown in Fig. 5, the measurement is based on six multipliers 26 of the pulse width-height type. By means of low-pass filtering $R_3C_1$ taking place in connection with the summing, high-frequency components are eliminated from the signals 41, 42 and 43, in which case the time average of said products remains, which time average is proportional to the power quantity that is supposed to be measured. The reference numeral 35 represents conventional operational amplifiers.

In the accompanying table, the arrangements of the control logic 24 between the pulsewidth modulators 21,22,23 and the switches 25 with different modes of measurement are illustrated.

Table

| Mode of measurement | Inputs | | Outputs | | | | | |
|---|---|---|---|---|---|---|---|---|
| | A | B | $Q_{1A}$ | $Q_{1B}$ | $Q_{2A}$ | $Q_{2B}$ | $Q_{3A}$ | $Q_{3B}$ |
| 3-mechanism efficient power | 1 | 0 | $D_{L1}$ | $\overline{D_{L1}}$ | $D_{L2}$ | $\overline{D_{L2}}$ | $D_{L3}$ | $\overline{D_{L3}}$ |
| 3-mechanism reactive power | 1 | 0 | $D_{L2}$ | $D_{L3}$ | $D_{L3}$ | $D_{L1}$ | $D_{L1}$ | $D_{L2}$ |
| 2-mechanism efficient power | 0 | 1 | $D_{L1}$ | $D_{L2}$ | - | - | $D_{L3}$ | $D_{L2}$ |
| | | or | - | - | $D_{L2}$ | $D_{L1}$ | $D_{L3}$ | $D_{L1}$ |
| | | or | $D_{L1}$ | $D_{L3}$ | $D_{L2}$ | $D_{L3}$ | - | - |
| 2-mechanism reactive power | 0 | 0 | $\overline{D_{L3}}$ | $D_{L3}$ | - | - | $D_{L1}$ | $\overline{D_{L1}}$ |
| | | or | - | - | $\overline{D_{L3}}$ | $D_{L3}$ | $D_{L2}$ | $\overline{D_{L2}}$ |
| | | or | $\overline{D_{L2}}$ | $D_{L2}$ | $D_{L1}$ | $\overline{D_{L1}}$ | - | - |

If, in some meter type, a possibility of internal change of mode of measurement is not needed, the control logic 24 can be omitted entirely. In such a case, the outputs of the pulse-width modulators 21,22,23 are connected directly to the switches 25 in accordance with the table.

Above, just the solution of principle of the invention has been described, and it is obvious for a person skilled in the art that numerous modifications can be made to said solution within the scope of the inventive idea defined in the accompanying claims.

In summary, the invention concerns a measurement circuit for measurement apparatuses intended for measurements of energy in a three-phase network, wherein output data are summed up in order to provide a result of measurement of energy. The measurement wiring 20 comprises pulse-width modulators 21,22,23, which form pulse-width modulated digital data $D_{L1}$, $D_{L2}$, $D_{L3}$ and negations $\overline{D_{L1}}$, $\overline{D_{L2}}$, $\overline{D_{L3}}$ of said digital data out of each momentary value of the phase voltage of the three-phase network, a pulse width-height multiplier 26 , and a control logic 24 , by means of which the control signals $Q_{1A}$, $Q_{1B}$, $Q_{2A}$, $Q_{2B}$, $Q_{3A}$, $Q_{3B}$ are chosen from said pulse-width modulated digital data ($D_{L1}$, $D_{L2}$, $D_{L3}$ and from their negations $\overline{D_{L1}}$, $\overline{D_{L2}}$, $\overline{D_{L3}}$ for the pulse width-height multiplier 26 . The secondary current $I_t$ of the measurement transformer (31,32,33) of each phase current of the three-phase network is passed to the pulse width-height multiplier 26 , the output 41,42,43 of said pulse width-height multiplier 26 being proportional to the energy quantity supposed to be measured at each particular time.

## Claims

1. Measurement circuit for measurement apparatuses intended for measurements of energy in a three-phase network, wherein output data are summed up in order to provide a result of measurement of the three-phase energy, the measurement wiring (20) comprising:

    (a) pulse-width modulators (21, 22, 23), which form pulse-width modulated digital data ($D_{L1}$, $D_{L2}$, $D_{L3}$) and negations ($\overline{D_{L1}}$, $\overline{D_{L2}}$, $\overline{D_{L3}}$) of said digital data out of each momentary value of the phase voltage of the three-phase network, and
    (b) a pulse width-height multiplier (26),

**characterized by**

(c) a control logic (24), by means of which control signals ($Q_{1A}$, $Q_{1B}$, $Q_{2A}$, $Q_{2B}$, $Q_{3a}$, $Q_{3B}$) are chosen from said pulse-width modulated digital data ($D_{L1}$, $D_{L2}$, $D_{L3}$) and from their negations ($\overline{D_{L1}}$, $\overline{D_{L2}}$, $\overline{D_{L3}}$) for said pulse width-height multiplier (26), and that the secondary current ($I_t$) of a measurement transformer (31, 32, 33) of each phase current of the three-phase network is passed to said pulse width-height multiplier (26), the output (41, 42, 43) of said pulse width-height multiplier (26) being proportional to the energy quantity to be measured.

2. Measurement circuit as claimed in claim 1, characterized in that the secondary current ($I_t$) of the measurement transformer (31, 32, 33) of each phase current in the three-phase network passes through two resistors ($R_1$) of equal size, and that the common point (34) of said resistors ($R_1$) is connected to the zero potential of the measurement electronics, whereby voltages of equal absolute value but of opposite signs, and proportional to the phase current are effective across the resistors ($R_1$).

3. Measurement circuit as claimed in claim 2, characterized in that said voltages are summed up when switches (25), that are connected between the measurement transformer (31, 32, 33) and the pulse width-height multiplier (26) and are controlled by the pulse-width modulators (21, 22, 23) and by the control logic (24) that determines the mode of measurement, are closed, in which case the summed signals (41, 42, 43) are proportional to the product of the phase current and the difference between the pulse widths that control said switches (25).

**Patentansprüche**

1. Meßanordnung für Meßgeräte zum Messen von Energie in einem Dreiphasennetz, wobei Ausgangsdaten aufsummiert werden, um ein Meßergebnis der elektrischen Dreiphasenenergie bereitzustellen, wobei die Meßanordnung (20)

Pulsbreitenmodulatoren (21, 22, 23), die pulsbreitenmodulierte digitale Daten ($D_{L1}$, $D_{L2}$, $D_{L3}$) sowie deren Negierung ($\overline{D_{L1}}$, $\overline{D_{L2}}$, $\overline{D_{L3}}$) aus jedem momentanen Wert der Phasenspannung des Dreiphasennetzes bilden, und
eine Impulsbreite-/höhe-Multiplikationseinrichtung (26) aufweist,

**gekennzeichnet durch**

eine Steuerlogik (24), mittels der Steuersignale ($Q_{1A}$, $Q_{1B}$, $Q_{2A}$, $Q_{2B}$, $Q_{3A}$, $Q_{3B}$) aus den pulsbreitenmodulierten digitalen Daten ($D_{L1}$, $D_{L2}$, $D_{L3}$) und aus deren Negierung ($\overline{D_{L1}}$, $\overline{D_{L2}}$, $\overline{D_{L3}}$) für die Impulsbreite-/höhe-Multiplikationseinrichtung (26) ausgewählt werden, und
wobei ein Sekundärstrom ($I_t$) eines Meßtransformators (31, 32, 33) jedes Phasenstroms in dem Dreiphasennetz zu der Impulsbreite-/höhe-Multiplikationseinrichtung (26) geführt wird, wobei das Ausgangssignal (41, 42, 43) der Impulsbreite-/höhe-Multiplikationseinrichtung 26 zu dem zu messenden Energiebetrag proportional ist.

2. Meßanordnung nach Anspruch 1, **dadurch gekennzeichnet, daß** der Sekundärstrom ($I_t$) des Meßtransformators (31, 32, 33) jedes Phasenstroms in dem Dreiphasennetz durch zwei Widerstände ($R_1$) gleicher Größe fließt und ein gemeinsamer Punkt (34) der Widerstände ($R_1$) mit dem Nullpotential der Meßelektronik verbunden ist, wodurch dem Phasenstrom proportionale Spannungen mit gleichem Absolutwert aber mit unterschiedlichen Vorzeichen an den Widerständen ($R_1$) anliegen.

3. Meßanordnung nach Anspruch 2, **dadurch gekennzeichnet, daß** die Spannungen aufsummiert werden, wenn Schalter (25) geschlossen werden, die zwischen dem Meßtransformator (31, 32, 33) und der Impulsbreite-/höhe-Multiplikationseinrichtung (26) angeschlossen sind und die durch die Pulsbreitenmodulatoren (21, 22, 23) und durch die die Meßbetriebsart bestimmende Steuerlogik (24) gesteuert werden, wobei in diesem Fall die summierten Signale (41, 42, 43) zu dem Produkt aus dem Phasenstrom und der Differenz zwischen den die Schalter (25) steuernden Pulsbreiten proportional sind.

**Revendications**

1. Circuit de mesure, pour appareils de mesure destinés à des mesures d'énergie dans un réseau triphasé, dans lequel des données de sortie sont sommées pour fournir un résultat de mesure de l'énergie triphasée, le câblage de mesure (20) comprenant:

   (a) des modulateurs de largeur d'impulsion (21, 22, 23) qui forment des données numériques modulées en largeur d'impulsion ($D_{L1}$, $D_{L2}$, $D_{L3}$) et des opposés ($\overline{D_{L1}}$, $\overline{D_{L2}}$, $\overline{D_{L3}}$) desdites données numériques à partir de chaque valeur instantanée de la tension de phase du réseau triphasé, et
   (b) un multiplicateur (26) de largeur-hauteur d'impulsion,

   caractérisé par

   (c) une logique de commande (24) au moyen de laquelle des signaux de commande ($Q_{1A}$, $Q_{1B}$, $Q_{2A}$, $Q_{2B}$, $Q_{3A}$, $Q_{3B}$) sont choisis à partir desdites données numériques modulées en largeur d'impulsion ($D_{L1}$, $D_{L2}$, $D_{L3}$), et de leurs opposés ($\overline{D_{L1}}$, $\overline{D_{L2}}$, $\overline{D_{L3}}$) pour ledit multiplicateur (26) de largeur-hauteur d'impulsion, et en ce que le courant secondaire ($I_t$) d'un transformateur de mesure (31, 32, 33) de chaque courant de phase du réseau triphasé est envoyé dans ledit multiplicateur (26) de largeur-hauteur d'impulsion, la sortie (41, 42, 43) dudit multiplicateur (26) de largeur-hauteur d'impulsion étant proportionnelle à la quantité d'énergie à mesurer.

2. Circuit de mesure selon la revendication 1, caractérisé en ce que le courant secondaire ($I_t$) du transformateur de mesure (31, 32, 33) de chaque courant de phase dans le réseau triphasé traverse deux résistances ($R_1$) de même valeur, et en ce que le point commun (34) desdites résistances ($R_1$) est connecté au potentiel nul de l'électronique de mesure, grâce à quoi des tensions de valeur absolue égale, mais de signes opposés et proportionnelles au courant de phase apparaissent aux bornes des résistances ($R_1$).

3. Circuit de mesure selon la revendication 2, caractérisé en ce que lesdites tensions sont sommées lorsque des commutateurs (25) qui sont connectés entre le transformateur de mesure (31, 32, 33) et le multiplicateur de largeur-hauteur d'impulsion (26) et sont commandés par les modulateurs de largeur d'impulsion (21, 22, 23) et par la logique de commande (24) qui détermine le mode de mesure, sont fermés, auquel cas les signaux sommés (41, 42, 43) sont proportionnels au produit du courant de phase et de la différence entre les largeurs d'impulsions qui commandent lesdits commutateurs (25).

FIG. 1

FIG. 2

FIG. 3

FIG. 4

**FIG. 5**